(19) Europäisches Patentamt / European Patent Office / Office européen des brevets

(11) **EP 3 358 377 A1**

(12) **EUROPEAN PATENT APPLICATION**
published in accordance with Art. 153(4) EPC

(43) Date of publication:
**08.08.2018 Bulletin 2018/32**

(51) Int Cl.:
*G02B 1/115* (2015.01)    *G03F 7/20* (2006.01)
*H01S 3/034* (2006.01)

(21) Application number: **16851404.0**

(22) Date of filing: **26.09.2016**

(86) International application number:
**PCT/JP2016/078183**

(87) International publication number:
**WO 2017/057233 (06.04.2017 Gazette 2017/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **30.09.2015  JP 2015193373**

(71) Applicant: **Nikon Corporation**
**Tokyo 108-6290 (JP)**

(72) Inventor: **MIZUGUCHI, Masafumi**
**Tokyo 108-6290 (JP)**

(74) Representative: **Viering, Jentschura & Partner mbB**
**Patent- und Rechtsanwälte**
**Grillparzerstraße 14**
**81675 München (DE)**

(54) **OPTICAL MEMBER, CHAMBER, AND LIGHT SOURCE DEVICE**

(57)    An optical member (100) is provided with a substrate (10) and a Cu-proof protective layer (23) formed on or above the substrate.

FIG. 1

**Description**

Technical Field

The present invention relates to an optical member including a protective film against copper (Cu), a chamber including the optical member, and a light source device including the chamber.

Background Art

Excimer lasers that generate pulses with light radiated from excimers formed from halogen atoms and excited noble gas atoms are widely used in the semiconductor manufacturing field, medical field, and the like. In the excimer lasers, XeCl excimer lasers that use xenon (Xe) as a noble gas and chlorine (Cl) as a halogen are used as light sources of excimer laser annealing devices and the like (Patent Document 1).

A XeCl excimer laser light source device mainly includes a chamber including a light transmitting window, and electrodes disposed in the chamber. A gas mixture containing xenon (Xe), hydrogen chloride (HCl), and the like is sealed in the chamber. When the XeCl excimer laser light source device operates, a large voltage difference is applied between the electrodes. This operation allows Xe atoms and excited Cl atoms to form excimers, and light radiated from the excimers is emitted outside through the light transmitting window of the chamber.

The electrodes in the chamber of the excimer laser light source device are made from W and/or Cu. It is reported that these materials are partially scattered by electrical discharge and thus cause fogging of the light transmitting window (Non Patent Document 1).

Citation List

Patent Literature

Patent Document 1: JP 2004-39660 A

Non Patent Literature

Non Patent Document 1: Applied Physics B63, PP229-235 (1996)
Non Patent Document 2: Jpn. J, Appl. Phys. Vol. 38 (1999) pp. 5792-5795

Summary of Invention

A first aspect of the present invention provides an optical member including: a substrate; and a Cu-proof protective layer formed on or above the substrate.

A second aspect of the present invention provides an optical member including: a substrate; and a transmitting film including: a low refractive index layer having a refractive index lower than that of the substrate; and a surface layer composed of any one of $Al_2O_3$, $Ta_2O_5$, MgO, and $HfO_2$ or a mixture of any two or more of $Al_2O_3$, $Ta_2O_5$, MgO, and $HfO_2$.

A third aspect of the present invention provides an optical member including: a substrate; and a multilayer film including a plurality of layers having mutually different refractive indices. The multilayer film includes a surface layer being a Cu-proof protective layer. The Cu-proof protective layer has a Cu diffusion coefficient at 200°C that is 1/10 or less of a Cu diffusion coefficient of $SiO_2$ at 200°C.

A fourth aspect of the present invention provides an optical member including: a substrate; and a multilayer film including a plurality of layers having mutually different refractive indices. The multilayer film includes a surface layer being a Cu-proof protective layer. The Cu-proof protective layer has a Cu diffusion coefficient at 200°C that is smaller than $1 \times 10^{-17}$ cm²/s. The optical member transmits 90% or greater of vertically incident light having a wavelength of 308 nm.

A fifth aspect of the present invention provides a chamber in which chlorine gas is sealed, the chamber including: a light transmitting window formed in the chamber. The light transmitting window is made of the optical member of any one of the first to fourth aspects.

A sixth aspect of the present invention provides a light source device including: the chamber of the fifth aspect; and an electrode disposed in the chamber and containing Cu.

A seventh aspect of the present invention provides a light transmitting window for an excimer laser light source device, the light transmitting window being made of the optical member of any one of the first to fourth aspects.

Brief Description of Drawings

FIG. 1 is a schematic cross-sectional view illustrating a configuration of an optical member according to an embodiment of the present invention.

FIG. 2 is a schematic cross-sectional view illustrating a configuration of a light source device according to the embodiment of the present invention.

FIG. 3 is a table showing configurations, transmittance, and the like of optical members of Examples 1 to 6 of the present invention.

FIG. 4 is a table showing configurations, transmittance, and the like of optical members of Comparative Examples 1 and 2.

FIG. 5 is an explanatory diagram illustrating a general configuration of a test device for testing Cu resistance of an optical member.

FIG. 6 is a graph showing the amount of Cu diffused in optical members.

FIG. 7 is a graph showing change in reflectance with respect to the wavelength of incident light, of each of the optical members of Examples 4 and 7 and the optical member of Comparative Example 1.

FIG. 8 is a graph showing change in transmittance with respect to the wavelength of incident light, of each of the optical members of Examples 4 and 7 and the optical member of Comparative Example 1.

FIGS. 9A, 9B, and 9C are explanatory diagrams illustrating the role of a surface layer having a film thickness d satisfying the condition $nd = \lambda/2$ with respect to incident light having a wavelength $\lambda$.

Description of Embodiments

In the present embodiment, a Cu-proof protective layer is provided as a surface layer (outermost layer or upper most layer) of an optical member. In the present specification, "Cu-proof protective layer" refers to a layer formed from a material that is difficult for Cu to enter. A material that is difficult for Cu to enter specifically refers to a material having a structure that is difficult for a univalent cation, such as $Na^+$, to enter. It tends to be difficult for Cu to enter a material having such a structure. One example of such a material that is difficult for Cu to enter is a material having a Cu diffusion coefficient (diffusion rate) at 200°C smaller than those of other materials (such as $SiO_2$). A layer formed from such a material functions as a Cu-proof protective layer. The diffusion coefficient (diffusion rate) can be measured with a generally used measuring method, for example, a dipping method. Examples of specific materials that have been found by the inventor of the present invention to be excellent for forming a Cu-proof protective layer include the aforementioned $HfO_2$, $Al_2O_3$, $Ta_2O_5$, and MgO.

A low refractive index layer having a refractive index lower than that of a substrate may be provided between the substrate and the Cu-proof protective layer. The low refractive index layer increases a difference in the refractive index between the layers, resulting in improvement in anti-reflection effect. Furthermore, by providing a high refractive index layer having a refractive index higher than that of the substrate between the substrate and the low refractive index layer, anti-reflection effect can be further improved.

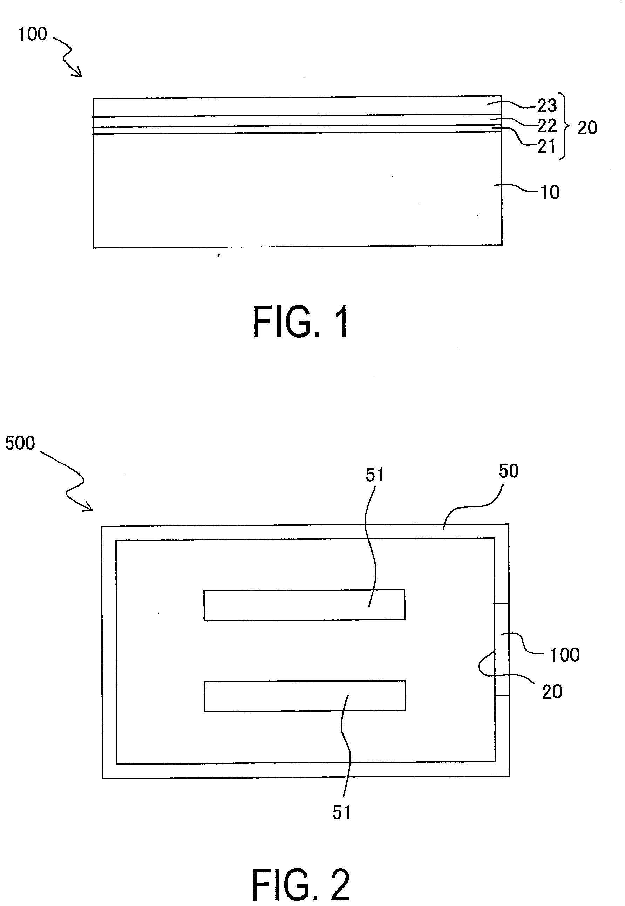

Embodiments for carrying out the present invention will be described in detail below with reference to the drawings. Herein, an example in which a high refractive index layer and a low refractive index layer are provided between a substrate and a Cu-proof protective layer is described. As illustrated in FIG. 1, an optical member 100 of the present embodiment includes a substrate 10 and a protective film 20 formed on the substrate 10. The protective film 20 includes a high refractive index layer 21 formed on the substrate 10, a low refractive index layer 22 formed on the high refractive index layer 21, and a Cu-proof protective layer 23 formed on the low refractive index layer 22, in this order from a side closer to the substrate 10.

Substrate

The substrate 10 can be formed from a desired light transmissive material. Examples of the light transmissive material include sapphire (aluminum oxide, $Al_2O_3$), magnesium fluoride ($MgF_2$), calcium fluoride ($CaF_2$), amorphous silica (amorphous $SiO_2$), and crystalline silica (crystal).

High Refractive Index Layer

The high refractive index layer 21 of the protective film 20 has a refractive index higher than that of the substrate 10, and is formed between the substrate 10 and the low refractive index layer 22, described hereinafter, in order to allow a greater amount of incident light transmitted through the low refractive index layer 22 to enter the substrate 10.

In a case where the substrate 10 is formed from sapphire (having a refractive index of 1.811 ($\lambda$ = 308 nm)), for example, the high refractive index layer 21 can be formed from an oxide, such as $HfO_2$ (having a refractive index of 2.053 ($\lambda$ = 308 nm)), $Ta_2O_5$ (having a refractive index of 2.277 ($\lambda$ = 308 nm)), and MgO (having a refractive index of 1.791 ($\lambda$ = 308 nm)).

The high refractive index layer 21 can be formed with a sputtering method or the like. The high refractive index layer 21 preferably has a film thickness $d_{21}$ of approximately 30 to 60 nm, and more preferably approximately 30 nm to 50 nm. Even more preferably, the film thickness $d_{21}$ of the high refractive index layer 21 satisfies the condition $n_{21}d_{21}$ = $\lambda/4$, where $n_{21}$ is a refractive index of the material forming the high refractive index layer 21 and $\lambda$ is a wavelength of light entering the optical member 100. By setting such a thickness, light reflected off the surface of the high refractive index layer 21 and light transmitted through the high refractive index layer 21 and reflected off the surface of the substrate 10 cancel out each other by interference, so that ideal anti-reflection effect is yielded. Note that the high refractive index layer 21 may be omitted.

Low Refractive Index Layer

The low refractive index layer 22 of the protective film 20 has a refractive index lower than that of the substrate 10, and is formed between the Cu-proof protective layer 23, described hereinafter, and the high refractive index layer 21, in order to allow a greater amount of incident light transmitted through the Cu-proof protective layer 23 to enter the substrate 10.

In a case where the substrate 10 is formed from sapphire (having a refractive index of 1.811 ($\lambda$ = 308 nm)), for example, the low refractive index layer 22 can be formed from $SiO_2$ (having a refractive index of 1.486 ($\lambda$ = 308 nm)), $MgF_2$ (having a refractive index of 1.399 ($\lambda$ = 308 nm)), $CaF_2$ (having a refractive index of 1.452 ($\lambda$ = 308 nm)), or the like.

The low refractive index layer 22 can be formed with a sputtering method or the like. The low refractive index layer 22 preferably has a film thickness $d_{22}$ of approximately 30 to 60 nm, and more preferably approximately 50 nm to 60 nm. Even more preferably, the film thickness $d_{22}$ of the low refractive index layer 22 satisfies the condition $n_{22}d_{22}$ = $\lambda/4$, where $n_{22}$ is a refractive index of the material forming the low refractive index layer 22 and $\lambda$ is a wavelength of light entering the optical member 100. By setting such a thickness, light reflected off the surface of the low refractive index layer 22 and light transmitted through the low refractive index layer 22 and reflected off the surface of the high refractive index layer 21 cancel out each other by interference, so that ideal anti-reflection effect is yielded.

Cu-proof Protective Layer

The Cu-proof protective layer 23 is formed as a surface layer of the protective film 20 to protect the optical member 100 against copper (Cu) flying toward the optical member 100. The Cu-proof protective layer 23 can be formed from, for example, $HfO_2$, $Al_2O_3$, $Ta_2O_5$, MgO, or a mixture thereof.

The Cu-proof protective layer 23 can be formed with a sputtering method or the like. The Cu-proof protective layer 23 preferably has a film thickness $d_{23}$ of approximately 60 to 120 nm, and more preferably approximately 60 nm to 90 nm. Even more preferably, the film thickness $d_{23}$ of the Cu-proof protective layer 23 satisfies the condition $n_{23}d_{23}$ = $\lambda/2$ as described below, where $n_{23}$ is a refractive index of the material forming the protective layer 23 and $\lambda$ is a wavelength of light entering the optical member 100.

Next, a case of using the optical member 100 of the present embodiment for a XeCl excimer laser light source device 500 will be described.

As illustrated in FIG. 2, the XeCl excimer laser light source device 500 mainly includes a chamber 50 and a pair of electrodes 51 disposed in the chamber 50. In the XeCl excimer laser light source device 500 having this configuration, the optical member 100 of the present embodiment can be used as a light transmitting window for allowing excimer laser light generated between the electrodes 51 to go outside the chamber 50.

Specifically, the optical member 100 is attached to a portion of the chamber 50 with the protective film 20 facing the interior of the chamber 50, as illustrated in FIG. 2. Sapphire, $MgF_2$, $CaF_2$, amorphous silica, and crystal listed above as examples of the material of the substrate 10, $HfO_2$ and the like listed as examples of the materials of the high refractive index layer 21 and the Cu-proof protective layer 23, and $SiO_2$ and the like listed above as examples of the material of the low refractive index layer 22 all ideally transmit XeCl excimer laser light having an emission wavelength (oscillation wavelength) of 308 nm. It is thus preferable to use these materials even when the optical member 100 is used as the light transmitting window of the excimer laser light source device 500.

The excimer laser light source device 500 including the optical member 100 of the present embodiment can be used as light sources for various uses, such as a laser annealing device, laser ablation, a laser knife, and an exposure device.

A gas mixture containing Xe, HCl, and the like is sealed in the chamber 50. When the XeCl excimer laser light source device 500 operates, a large voltage difference is applied between the electrodes 51. This operation allows Xe atoms and excited Cl atoms to form excimers, and the excimers radiate laser light having a wavelength of 308 nm. The laser light generated in the chamber is transmitted through the optical member 100 and goes outside the chamber 50.

The electrodes 51 of the XeCl excimer laser light source device 500 typically contain copper (Cu). When a large voltage difference is applied between the electrodes 51 to generate excimer laser light, Cu contained in the electrodes 51 is scattered around. The inventor of the present invention examined fogging of the light transmitting window of the chamber and found that some fogging was not removed even by wiping. It was found by this finding that Cu was not only attached to the surface but also entered inside from the surface.

Here, in the XeCl excimer laser light source device 500 including the optical member 100 of the present embodiment as the light transmitting window, the protective film 20 including the Cu-proof protective layer 23 as the surface layer is formed on the surface, facing the interior of the chamber 50, of the optical member 100. This configuration prevents the light transmitting window (optical member 100) from being contaminated because of entering of Cu, in the XeCl excimer laser light source device 500.

In this way, the protective film 20 of the optical member 100 is used in such a severe environment that the protective film 20 is exposed to the gas mixture containing HCl and the like and laser light. Thus, the Cu-proof protective layer being the surface layer of the protective film 20 desirably has high chemical stability and a solubility of 10 ppm or less in pure water at 20°C.

Examples

The optical member 100 will be described below using Examples. However, the present invention is not limited to these Examples. Note that a sputtering method is used for film formation in all of Examples and Comparative Examples below.

Example 1

A disk made from sapphire and having a diameter of 60 mm and a thickness of 5 mm was used as a substrate. The c-plane of the sapphire was parallel to the circular plane having a diameter of 60 mm. The substrate had an internal transmittance of 99.9% or greater for light having a wavelength of 308 nm.

A $SiO_2$ layer having a film thickness d of 0.052 $\mu$m was formed on the sapphire substrate, as a low refractive index layer. This film thickness d substantially satisfied the condition nd = $\lambda$/4, where n = 1.486 and $\lambda$ = 308 nm. Then, a $HfO_2$ layer having a film thickness d of 0.038 $\mu$m was formed on the $SiO_2$ layer, as a Cu-proof protective layer. This film thickness d substantially satisfied the condition nd = $\lambda$/4, where n = 2.053 and $\lambda$ = 308 nm.

The transmittance of the optical member of Example 1 for light having a wavelength 308 nm was calculated through simulation to be 76.8%.

Example 2

An optical member of Example 2 had the same configuration as that of the optical member of Example 1, except for a $HfO_2$ layer formed as a Cu-proof protective layer, that had a thickness of 0.075 $\mu$m. The film thickness d of the $HfO_2$ layer being the Cu-proof protective layer substantially satisfied the condition nd = $\lambda$/2, where n = 2.053 and $\lambda$ = 308 nm.

The transmittance of the optical member of Example 2 for light having a wavelength of 308 nm was calculated through simulation to be 96.2%.

Example 3

An optical member of Example 3 had the same configuration as that of the optical member of Example 1, except for a $HfO_2$ layer provided as a high refractive index layer between the substrate and the low refractive index layer.

The $HfO_2$ layer having a film thickness d of 0.038 $\mu$m was formed as the high refractive index layer on the substrate. This film thickness d substantially satisfied the condition nd = $\lambda$/4, where n = 2.053 and $\lambda$ = 308 nm. On this $HfO_2$ layer, the $SiO_2$ layer being the low refractive index layer and the $HfO_2$ layer being the Cu-proof protective layer were formed. Note that both the surface layer and the layer formed between the substrate and the low refractive index layer were $HfO_2$ layers in Example 3, and the $HfO_2$ layer being the surface layer is referred to as Cu-proof protective layer and the $HfO_2$ layer formed between the substrate and the low refractive index layer is referred to as high refractive index layer. This also applies to Examples 4 to 6, described hereinafter.

The transmittance of the optical member of Example 3 for light having a wavelength of 308 nm was calculated through simulation to be 64.4%.

Example 4

An optical member of Example 4 had the same configuration as that of the optical member of Example 3, except for a HfO$_2$ layer formed as a Cu-proof protective layer, that had a thickness of 0.075 $\mu$m. The film thickness d of the HfO$_2$ layer being the Cu-proof protective layer substantially satisfied the condition nd = $\lambda$/2, where n = 2.053 and $\lambda$ = 308 nm.
The transmittance of the optical member of Example 4 for light having a wavelength of 308 nm was calculated through simulation to be 99.9%.

Example 5

An optical member of Example 5 had the same configuration as that of the optical member of Example 3, except for a SiO$_2$ layer formed as a low refractive index layer, that had a thickness of 0.104 $\mu$m. The film thickness d of the SiO$_2$ layer formed as the low refractive index layer substantially satisfied the condition nd = $\lambda$/2, where n = 1.486 and $\lambda$ = 308 nm.
The transmittance of the optical member of Example 5 for light having a wavelength of 308 nm was calculated through simulation to be 88.0%.

Example 6

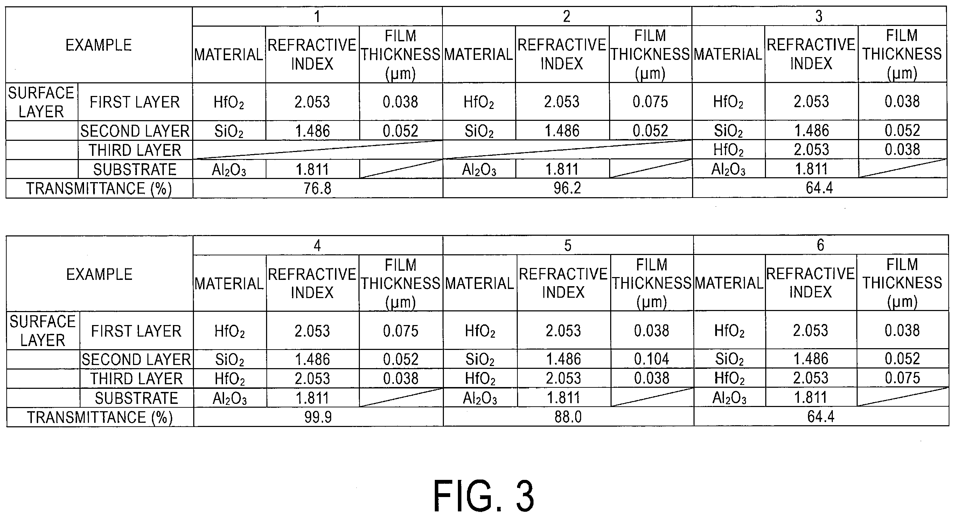

An optical member of Example 6 had the same configuration as that of the optical member of Example 3, except for a HfO$_2$ layer formed as a high refractive index layer, that had a thickness of 0.075 $\mu$m. The film thickness d of the HfO$_2$ layer formed as the high refractive index layer substantially satisfied the condition nd = $\lambda$/2, where n = 2.053 and $\lambda$ = 308 nm.
The transmittance of the optical member of Example 6 for light having a wavelength of 308 nm was calculated through simulation to be 64.4%.
The table in FIG. 3 shows the summary of the optical members of Examples 1 to 6, with respect to the configurations thereof, the refractive indices and film thicknesses of the layers of the protective films, the refractive indices of the substrates, and the transmittance of the optical members.

Comparative Example 1

An optical member of Comparative Example 1 was prepared by forming the HfO$_2$ layer and the SiO$_2$ layer on the substrate in the same manner as those of Examples 3 and 4, except that no HfO$_2$ layer was provided as a Cu-proof protective layer.. The transmittance of the optical member of Comparative Example 1 for light having a wavelength of 308 nm was calculated through simulation to be 99.9%.

Comparative Example 2

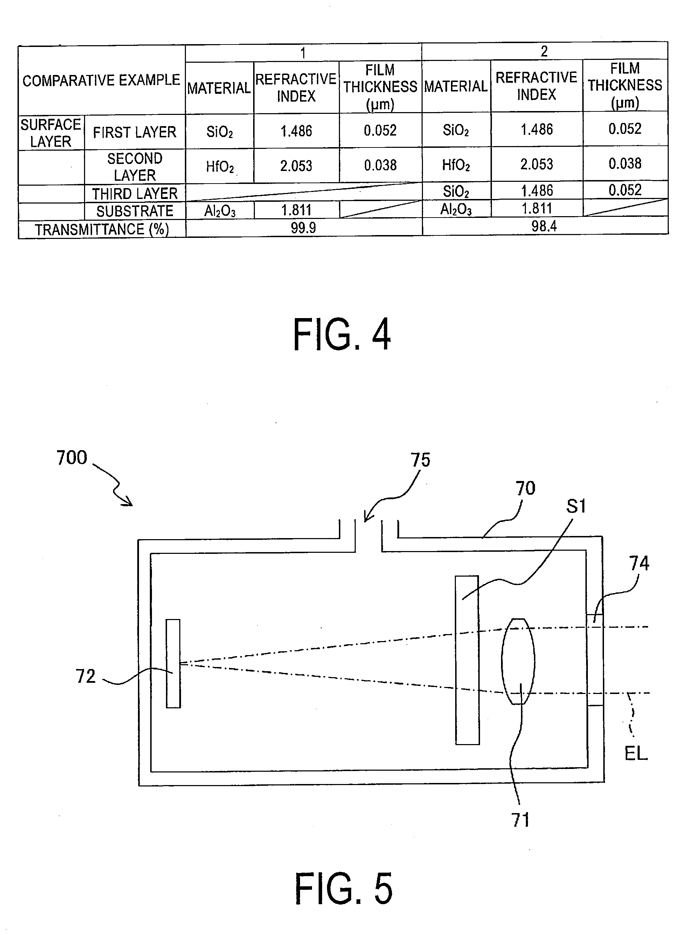

An optical member of Comparative Example 2 was prepared by laminating a SiO$_2$ layer, a HfO$_2$ layer, and a SiO$_2$ layer in this order from the substrate side, which was opposite to the optical members of Examples 3 to 6 prepared by laminating the HfO$_2$ layer, the SiO$_2$ layer, and the HfO$_2$ layer in this order from the substrate side. The SiO$_2$ layers each had a thickness of 0.052 $\mu$m, and the HfO$_2$ layer had a thickness of 0.038 $\mu$m.
The transmittance of the optical member of Comparative Example 2 for light having a wavelength of 308 nm was calculated through simulation to be 98.4%.
The table in FIG. 4 shows the summary of the optical members of Comparative Examples 1 and 2, with respect to the configurations thereof, the refractive indices and film thicknesses of the layers of the films, the refractive indices of the substrates, and the transmittance of the optical members.

Cu Attachment Test

The following Cu attachment test for the optical members of Examples 1 to 6 and the optical members of Comparative Examples 1 and 2 was conducted to check resistance to Cu particles flying from the electrodes 51 and the like. Note that the resistance of the optical members of Examples 1 to 6 to flying Cu particles is mainly equal to resistance of the HfO$_2$ layers being the surface layers (Cu-proof protective layers) to Cu particles. Thus, in the following Cu attachment test, a sample S1 in which a HfO$_2$ film having a film thickness d of 0.075 $\mu$m was formed on the surface of a SiO$_2$ substrate was used as a typified optical member of the optical members of Examples 1 to 6. For the same reason, a sample S2 in which a SiO$_2$ film having a film thickness d of 0.052 $\mu$m was formed on the surface of a SiO$_2$ substrate

6

was used as a typified optical member of the optical members of Comparative Examples 1 and 2. The Cu attachment test was also conducted for a $SiO_2$ substrate with no film formed on its surface (sample S3).

As illustrated in FIG. 5, a test device 700 used in the Cu attachment test includes a quartz chamber 70 provided with a light transmitting window 74, a condensing lens 71 disposed in the chamber 70 and concentrating light entering from the light transmitting window 74, and a copper plate 72 disposed in the chamber 70 and arranged in the focal position of the condensing lens 71 while facing the condensing lens 71. The chamber 70 includes an opening 75 for creating a vacuum in the chamber 70.

The Cu attachment test was conducted using the following procedure. First, the sample S1 was placed between the condensing lens 71 and the copper plate 72 as illustrated in FIG. 5. At this time, the sample S1 was placed substantially parallel to the condensing lens 71 and the copper plate 72, and the $HfO_2$ film faced the copper plate 72. The distance between the sample S1 and the copper plate 72 was approximately 6 cm.

Next, air in the chamber 70 was discharged through the opening 75 of the chamber 70 to create a vacuum of approximately 1 Pa in the chamber 70. Then, as illustrated in FIG. 5, XeCl excimer laser light EL having a repetition frequency of 100 Hz and a radiation power of 100 mJ was radiated through the light transmitting window 74. The XeCl excimer laser light EL transmitted through the condensing lens 71 and the sample S1 was then concentrated on the copper plate 72, and Cu particles removed (emitted) from the copper plate 72, on a principle similar to that of a laser ablation method, flew to the $HfO_2$ film of the sample S1. The XeCl excimer laser light EL was radiated for 600 seconds.

Concerning the radiated XeCl excimer laser light EL, the beam size at the sample S1 was 2 cm × 0.5 cm, the radiation fluence at the sample S was 100 mJ/cm², the beam size at the copper plate 72 was approximately 2 mm × 1 mm, and the radiation fluence at the copper plate 72 was 5 J/cm².

After the radiation, the sample S1 was taken out of the test device 700, and powder attached to its surface was wiped out. The same steps were taken to radiate XeCl excimer laser light EL toward the sample S2 and the sample S3.

After the radiation, (1) visual inspection of a condition of the surface, (2) measurement of a difference in transmittance (transmittance before the radiation - transmittance after the radiation), and (3) time-of-flight secondary ion mass spectrometric analysis (TOF-SIMS analysis) were performed for each of the samples S1, S2, and S3.

(1) Visual Inspection

Before visual inspection, dirt was wiped out with a wiping cloth with ethanol applied thereto. Then, inspection was performed. No Cu particles entering the sample S1 were observed. The sample S2 was observed to have white fogging. Cu particles attached to the sample S2 chemically reacted with the $SiO_2$ film and could not be wiped out. The sample S3 was also observed to have white fogging. Cu particles attached to the sample S3 chemically reacted with the $SiO_2$ substrate and could not be wiped out.

(2) Difference in Transmittance

Table 1 below shows a difference in transmittance calculated for each of the sample S1, the sample S2, and the sample S3. The transmittance of the sample S1 changed little between before and after the radiation of the XeCl excimer laser light EL. In contrast, the transmittance of the samples S2, S3 after the radiation of the XeCl excimer laser light EL deteriorated by approximately 4% in comparison with before the radiation. It is considered that this was caused by a chemical reaction between Cu particles and the $SiO_2$ film or the $SiO_2$ substrate as described above.

[Table 1]

| Sample | Difference in transmittance |
|--------|------------------------------|
| S1 | 0.1 |
| S2 | 3.5 |
| S3 | 4.4 |

(3) TOF-SIMS

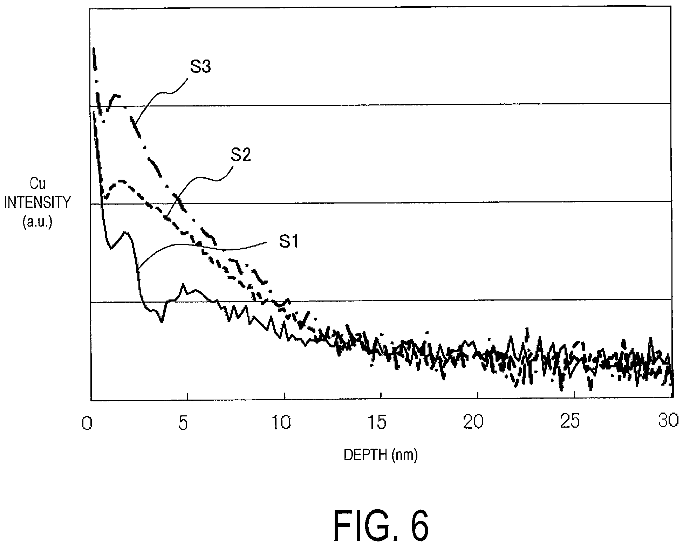

TOF-SIMS analysis was performed for each of the samples S1 to S3 to check intensity of Cu entering the sample. FIG. 6 is a graph of the analysis results. The horizontal axis indicates depth (nm) from a sample surface, and the vertical axis indicates Cu intensity (corresponding to the amount of Cu) in an arbitrary unit. In FIG. 6, the solid line indicates the analysis result of the sample S1, the dotted line indicates the analysis result of the sample S2, and the dashed-dotted line indicates the analysis result of the sample S3.

In FIG. 6, a greater tilt to the lower right of the graph indicates that Cu particles are more difficult to enter. It is understood from the results that $HfO_2$ was more difficult to react with Cu than $SiO_2$ was, and that Cu particles were thus prevented from entering the $HfO_2$ film of the sample S1.

As shown in FIG. 6, as the depth (nm) from the sample surface becomes greater, Cu intensity of $HfO_2$ decreases more significantly than that of $SiO_2$. A material, such as $HfO_2$, that is more difficult for Cu to enter than $SiO_2$ is, that is, a material having a Cu diffusion coefficient smaller than that of $SiO_2$ is suitable for forming the "Cu-proof protective layer" of the present invention, and a material having a Cu diffusion coefficient at 200°C that is 1/10 or less of that of $SiO_2$ at 200°C is more suitable for forming the "Cu-proof protective layer" of the present invention. The temperature of the optical member 100 of the present embodiment used as a window member of the light source device 500 of the present embodiment, during the use of light source device 500, is approximately 200°C.

Note that as described in Non Patent Document 2, the Cu diffusion coefficient D of $SiO_2$ can be obtained by Equation (1) below:

[Equation 1]

$$\text{Equation 1}$$

$$D = D_0 e^{-\frac{E_a}{kT}}$$

where $D_0$ is a pre-exponential factor, Ea is activation energy of diffusion, k is the Boltzmann constant, and T is a temperature. According to Equation (1), the Cu diffusion coefficient D of $SiO_2$ at 200°C is $1.03 \times 10^{-16}$ cm$^2$/s. Thus, for example, the Cu diffusion coefficient of a material suitable for forming the Cu-proof protective layer, at 200°C, is desirably smaller than $1 \times 10^{-17}$ cm$^2$/s.

It is understood from the aforementioned test that the optical members of Examples 1 to 6 including a $HfO_2$ layer as the Cu-proof protective layer being the surface layer are more difficult to react with Cu particles and have higher Cu resistance than the optical members of Comparative Examples 1 and 2 including a $SiO_2$ layer being the surface layer.

Wavelength Dependence of Transmittance and Reflectance

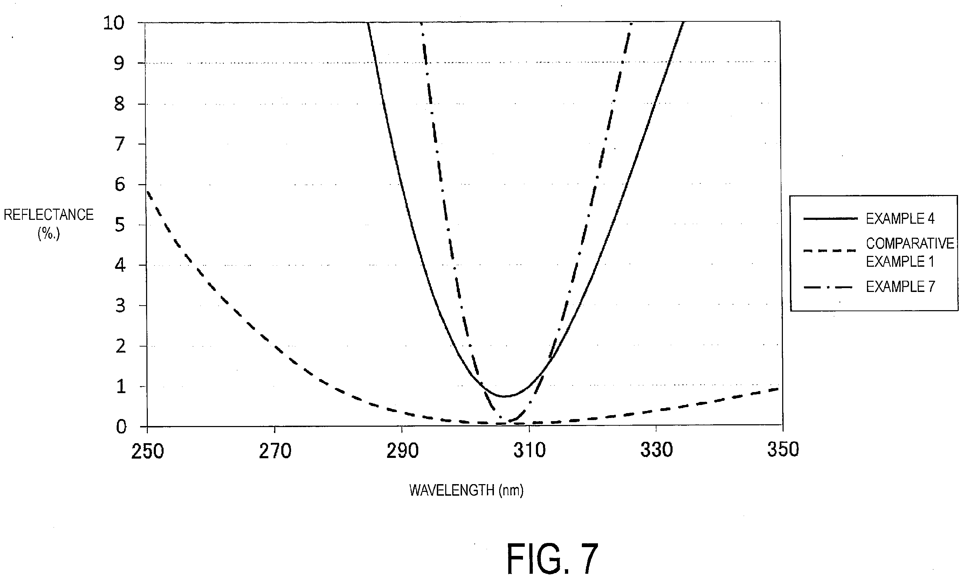

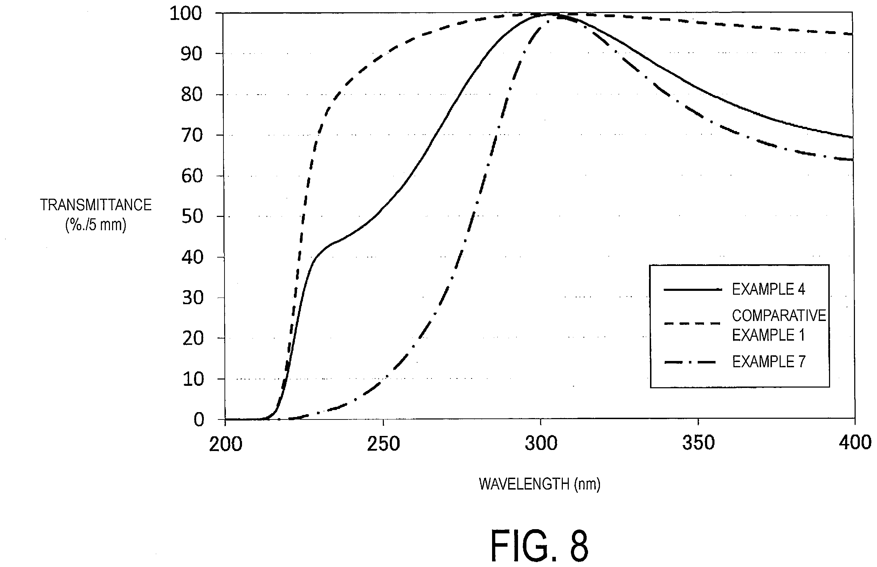

Next, the spectral reflectance and spectral transmittance of the optical member of Example 4 and the optical member of Comparative Example 1 were measured. FIG. 7 shows change in reflectance with respect to the wavelength of incident light, and FIG. 8 shows change in transmittance with respect to the wavelength of incident light. Reflectance was measured with a micro-spectrophotometer USPM-RUIII or N&k Analyzer 1280 (n&k Technology), and transmittance was measured with CARY-5000. In each of FIGS. 7 and 8, the solid line indicates a graph of the optical member of Example 4, and the dotted line indicates a graph of the optical member of Comparative Example 1.

With reference to FIG. 7, the optical member of Example 4 had the lowest reflectance of approximately 0.7% at a wavelength of around 308 nm. The reflectance was 1% or less in a wavelength region of approximately 296 to 310 nm. This indicates that the protective film of the optical member of Example 4 offers sufficiently high performance as an anti-reflection film in addition to a protective film, against incident light having a wavelength of approximately 308 nm. Note that the optical member of Comparative Example 1 had a reflectance of 1% or less in a wider wavelength region of approximately 280 nm to approximately 350 nm.

With reference to FIG. 8, the optical member of Example 4 had the highest transmittance of 99% or greater at a wavelength of around 308 nm. The transmittance was 90% or greater in a wavelength region of approximately 280 nm to 330 nm. This indicates that the protective film of the optical member of Example 4 offers sufficiently high performance as an anti-reflection film in addition to a protective film, against incident light having a wavelength of approximately 308 nm. Note that the optical member of Comparative Example 1 had a transmittance of 90% or greater in a wider wavelength region of approximately 250 nm to 400 nm or greater.

In this way, although it is shown within a relatively small wavelength region, the optical member of Example 4 has ideal anti-reflection characteristics similar to the optical member of Comparative Example 1. The above-described results of the Cu attachment test clearly demonstrate that when the optical member of Comparative Example 1 is used in such an environment that Cu particles may fly to the optical member, the transmittance of the optical member decreases significantly because of a reaction with Cu particles. Thus, when the optical member of Comparative Example 1 is used as a light transmitting window of a chamber of a XeCl excimer laser light source device, for example, the window needs to be replaced frequently. In contrast, the optical member of Example 4 has ideal anti-reflection characteristics and is difficult to decrease its transmittance even in a case where Cu flies to the optical member, and can thus be used as a long-life window member of a chamber of a XeCl excimer laser light source device.

Note that FIGS. 7 and 8 also show reflectance and transmittance of an optical member of Example 7. The optical member of Example 7 had the same configuration as that of the optical member of Example 4, except for a Cu-proof protective layer formed from $Ta_2O_5$ instead of $HfO_2$. The film thickness d of the Cu-proof protective layer formed from $Ta_2O_5$ was 0.068 $\mu$m and substantially satisfied the condition nd = $\lambda$/2, where n = 2.277 and $\lambda$ = 308 nm.

The optical member of Example 7 had the lowest reflectance of approximately 0.2% at a wavelength of around 308 nm and a reflectance of 1% or less in a wavelength region of approximately 296 to 312 nm. This optical member had the highest transmittance of 99% or greater at a wavelength of around 308 nm and a reflectance of 90% or greater in a wavelength region of approximately 290 nm to 320 nm. This indicates that the protective film of the optical member of Example 7 offers sufficiently high performance as an anti-reflection film in addition to a protective film, against incident light having a wavelength of 308 nm.

Like the above-described optical members of Examples 4 and 7, when the film thickness d of a Cu-proof protective layer of an optical member substantially satisfied the condition nd = $\lambda$/2 where the wavelength $\lambda$ = 308 nm, the optical member exhibited ideal anti-reflection characteristics against light having a wavelength of 308 nm. The reason can be considered as described below.

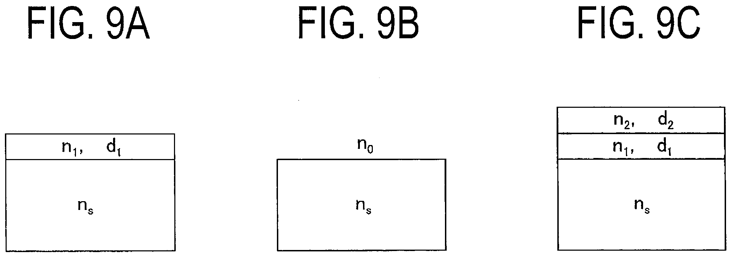

When a single-layer film having a refractive index $n_1$ and a film thickness $d_1$ is provided on a substrate having a refractive index $n_s$ as illustrated in FIG. 9A, the reflectance of the single-layer film for vertically incident light having a wavelength $\lambda$ is represented by Equation (2) below:

[Equation 2]

$$\text{Equation 2}$$

$$R = \frac{(A - n_s D)^2 + (n_s B - C)^2}{(A + n_s D)^2 + (n_s B + C)^2}$$

Here, each of A, B, C, and D in Equation (2) can be obtained by obtaining $\delta$ with Equation (3) below, by applying nd = $n_1 d_1$ to Equation (3), and then inserting the obtained value $\delta$ into Equation (4) (characteristics matrix) below:

[Equation 3]

$$\text{Equation 3}$$

$$\delta = \frac{2\pi}{\lambda} \, nd$$

[Equation 4]

$$\text{Equation 4}$$

$$\begin{bmatrix} A & iB \\ iC & D \end{bmatrix} = \begin{bmatrix} \cos\delta & \dfrac{i}{n}\sin\delta \\ in\sin\delta & \cos\delta \end{bmatrix} = M$$

When the film thickness $d_1$ satisfies the condition $n_1 d_1 = \lambda/2$, Equation (3) provides $\delta = \pi$, and Equation (4) provides A = - 1, B = 0, C = 0, and D = - 1. Equation (2) thus provides Reflectance R = $(1 - n_s)^2/(1 + n_s)^2$.

On the other hand, when a substrate having a refractive index $n_s$ is placed in a medium having a refractive index $n_0$ as illustrated in FIG. 9B, Reflectance $R_0$ of the substrate for vertically incident light can be obtained by Equation (5) below:

[Equation 5]

Equation 5

$$R_0 = \frac{(n_0 - n_s)^2}{(n_0 + n_s)^2}$$

Here, providing $n_0 = 1$ because the refractive index of air is 1, Equation (5) provides $(1 - n_s)^2/(1 + n_s)^2$. This is equal to the reflectance of the aforementioned optical member having the single-layer film having a film thickness $d_1$ satisfying the condition $n_1 d_1 = \lambda/2$. That is, the reflectance for vertically incident light having a wavelength $\lambda$, of an optical member in which a single-layer film having a film thickness $d_1$ satisfying the condition $n_1 d_1 = \lambda/2$ is formed on a substrate is theoretically equal to the reflectance for vertically incident light having a wavelength $\lambda$, of a substrate without a single-layer film.

Next, a multilayer film in which a second layer having a refractive index $n_2$ and a film thickness $d_2$ is formed on a first layer having a refractive index $n_1$ and a film thickness $d_1$ as illustrated in FIG. 9C will be examined. The film thickness $d_1$ of the first layer satisfies the condition $n_1 d_1 = \lambda/4$, and the film thickness $d_2$ of the second layer satisfies the condition $n_2 d_2 = \lambda/2$.

At this time, the characteristics matrix M of the multilayer film is represented by Equation (6) below:
[Equation 6]

Equation 6

$$M = M_2 M_1 = \begin{bmatrix} -1 & 0 \\ 0 & -1 \end{bmatrix} \begin{bmatrix} 0 & \dfrac{i}{n_1} \\ in_1 & 0 \end{bmatrix} = \begin{bmatrix} 0 & -\dfrac{i}{n_1} \\ -in_1 & 0 \end{bmatrix} = \begin{bmatrix} A & iB \\ iC & D \end{bmatrix}$$

where $M_1$ is the characteristics matrix of the first layer and $M_2$ is the characteristics matrix of the second layer. Equation (6) provides $A = 0$, $B = - (1/n_1$, $C = - n_1$, and $D = 0$, and Equation (2) thus provides the reflectance of the multilayer film for vertically incident light having a wavelength $\lambda$ as $R = (n_s - n_1{}^2)^2/(n_s + n_1{}^2)^2$.

Furthermore, a single-layer film obtained by removing the second layer from the multilayer film illustrated in FIG. 9C will be examined. The characteristics matrix M1 of the first layer is represented by Equation (7) below:
[Equation 7]

Equation 7

$$M_1 = \begin{bmatrix} 0 & \dfrac{i}{n_1} \\ in_1 & 0 \end{bmatrix} = \begin{bmatrix} A & iB \\ iC & D \end{bmatrix}$$

This provides $A = 0$, $B = 1/n_1$, $C = n_1$, and $D = 0$. Equation (2) thus provides the reflectance for vertically incident light having a wavelength $\lambda$, of the single-layer film formed by only the first layer as $R = (n_s - n_1{}^2)^2/(n_s + n_1{}^2)^2$, which is the same as the reflectance of the aforementioned multilayer film. That is, the reflectance for vertically incident light having a wavelength $\lambda$, of an optical member in which a multilayer film including a layer, as a surface layer, having a film thickness $d_2$ satisfying the condition $n_2 d_2 = \lambda/2$ is formed on a substrate is theoretically equal to the reflectance for vertically incident light having a wavelength $\lambda$, of an optical member in which an optical thin film obtained by removing the surface layer from the above multilayer film is formed on a substrate.

Here, the optical member of Example 4 had the same film configuration as that of the optical member of Comparative Example 1, except for the $HfO_2$ layer as the Cu-proof protective layer being the surface layer. Similarly, the optical member of Example 7 had the same film configuration as that of the optical member of Comparative Example 1, except for the $Ta_2O_5$ layer as the Cu-proof protective layer being the surface layer. The film thickness d of the $HfO_2$ layer of Example 4 and the film thickness d of the $Ta_2O_5$ layer of Example 7 with respect to incident light having a wavelength $\lambda$ of 308 nm satisfied the condition $nd = \lambda/2$. Thus, the protective films of the optical members of Examples 4 and 7 have reflectance equivalent to that of the optical member of Comparative Example 1 for incident light having a wavelength of 308 nm, and in other words, also function as an ideal anti-reflection film against light having a wavelength of 308 nm.

Effects of the optical members of the aforementioned embodiment and Examples will be summarized below.

The optical member 100 of the aforementioned embodiment includes the Cu-proof protective layer 23 as the surface layer, so that even in a case where Cu particles fly to the optical member from a surrounding environment, diffusion of Cu particles in the Cu-proof protective layer 23 is reduced. The optical member 100 of the present embodiment can thus be used for a long period while preventing a decrease in transmittance even in such an environment that Cu particles fly to the optical member.

In the XeCl excimer laser light source device, chlorine gas is sealed in the chamber, and Cu particles fly from the electrodes. The optical member 100 of the present embodiment includes the Cu-proof protective layer 23 as the surface layer, made from a material that is chemically stable toward chlorine gas, that prevents Cu particles from entering by diffusion, and that efficiently transmits light having a wavelength of 308 nm. The optical member 100 of the present embodiment can thus be used suitably as the light transmitting window of the chamber of the XeCl excimer laser light source device.

The optical member 100 of the present embodiment prevents a decrease in transmittance in such an environment that Cu particles or the like fly to the optical member. The chamber 50 and the light source device 500 of the present embodiment include, as the light transmitting window, the optical member 100 preventing a decrease in transmittance in such an environment that Cu particles or the like fly to the optical member, so that the frequency of maintenance can be reduced.

In the optical member 100 of the aforementioned embodiment, the film thickness d of the Cu-proof protective layer 23 being the surface layer of the protective film 20 with respect to incident light having a wavelength $\lambda$ is set to satisfy the condition nd = $\lambda/2$, so that the reflectance of the protective film 20 for incident light having a wavelength $\lambda$ can be equivalent to a reflectance, for incident light having a wavelength $\lambda$, of the optical thin film obtained by removing the Cu-proof protective layer 23 being the surface layer from the protective film 20. Thus, by forming an optical thin film having sufficiently small reflectance for incident light having a desired wavelength $\lambda$ and forming the Cu-proof protective layer 23 having a film thickness d satisfying the condition nd = $\lambda/2$, on the optical thin film as the surface layer, an optical thin film that can be used as an anti-reflection film for the desired wavelength $\lambda$ and functions as a protective film for flying Cu particles can be achieved.

In the optical member 100 of the aforementioned embodiment, by setting the film thicknesses of the high refractive index layer 21, the low refractive index layer 22, and the Cu-proof protective layer 23 as those of Example 4, an optical thin film having both Cu resistance and anti-reflection characteristics can be formed. Such an optical thin film has a reflectance of 1% or less for light in a wide wavelength region of approximately 296 to 310 nm and a transmittance of 90% or greater for light in a wide wavelength region of approximately 280 nm to 330 nm. Thus, even in a case where variation in temperature, the film thickness or the like changes the performance of the protective film a little, low reflectance and high transmittance can be maintained for incident light having a wavelength of 308 nm.

Note that the protective film 20 of the aforementioned embodiment may have four or more layers. In this case, it is desirable that underlying layers of the Cu-proof protective layer 23 include high refractive index layers having a refractive index higher than that of a substrate and low refractive index layers having a refractive index lower than that of the substrate, and that the high refractive index layers and the low refractive index layers are alternately formed.

Provided that the features of the present invention are ensured, the present invention is not limited to the embodiments described above, and other embodiments that embody the technical concepts of the present invention are also included within the scope of the present invention.

Reference Signs List

    10 Substrate
    20 Protective film
    21 High refractive index layer
    22 Low refractive index layer
    23 Cu-proof protective layer
    50, 70 Chamber
    51 Electrode
    71 Condensing lens
    72 Copper plate
    100 Optical member
    500 XeCl excimer laser light source device
    700 Test device

**Claims**

1. An optical member comprising:

   a substrate; and
   a Cu-proof protective layer formed on or above the substrate.

2. The optical member according to claim 1, further comprising a low refractive index layer formed between the substrate and the Cu-proof protective layer, the low refractive index layer having a refractive index lower than a refractive index of the substrate.

3. The optical member according to claim 1 or 2, wherein the low refractive index layer and/or the Cu-proof protective layer functions as an anti-reflection film.

4. The optical member according to claim 2 or 3, wherein the low refractive index layer is a $SiO_2$ layer.

5. The optical member according to any one of claims 1 to 4, wherein the optical member has a transmittance of 90% or greater for vertically incident light having a wavelength of 308 nm.

6. An optical member comprising:

   a substrate; and
   a transmitting film comprising:

      a low refractive index layer having a refractive index lower than that of the substrate; and
      a surface layer composed of any one of $Al_2O_3$, $Ta_2O_5$, MgO, and $HfO_2$ or a mixture of any two or more of $Al_2O_3$, $Ta_2O_5$, MgO, and $HfO_2$.

7. The optical member according to claim 6, wherein the transmitting film functions as an anti-reflection film.

8. The optical member according to claim 6 or 7, wherein the low refractive index layer is a $SiO_2$ layer.

9. The optical member according to any one of claims 6 to 8, wherein the surface layer has a thickness satisfying a condition $nd = \lambda/2$, where $\lambda$ is a wavelength of light entering the optical member and $n$ is a refractive index of the surface layer.

10. The optical member according to any one of claims 6 to 9, wherein the optical member has a transmittance of 90% or greater for vertically incident light having a wavelength of 308 nm.

11. The optical member according to any one of claims 6 to 10, wherein the surface layer is a $HfO_2$ layer.

12. The optical member according to any one of claims 6 to 11, further comprising a high refractive index layer formed between the substrate and the low refractive index layer, the high refractive index layer having a refractive index higher than a refractive index of the substrate.

13. The optical member according to claim 12, wherein the surface layer and the high refractive index layer are composed of a same material.

14. An optical member comprising:

   a substrate; and
   a multilayer film comprising a plurality of layers having mutually different refractive indices;
   the multilayer film comprising a surface layer being a Cu-proof protective layer, and
   the Cu-proof protective layer having a Cu diffusion coefficient at 200°C that is 1/10 or less of a Cu diffusion coefficient of $SiO_2$ at 200°C.

15. The optical member according to claim 14, wherein the optical member has a transmittance of 90% or greater for vertically incident light having a wavelength of 308 nm.

**16.** An optical member comprising:

a substrate; and
a multilayer film comprising a plurality of layers having mutually different refractive indices;
the multilayer film comprising a surface layer being a Cu-proof protective layer,
the Cu-proof protective layer having a Cu diffusion coefficient at 200°C that is smaller than $1 \times 10^{-17}$ cm$^2$/s, and
the optical member transmitting 90% or greater of vertically incident light having a wavelength of 308 nm.

**17.** The optical member according to claim 16, wherein the Cu-proof protective layer has a solubility of 10 ppm or less in pure water at 20°C.

**18.** The optical member according to any one of claims 14 to 17, wherein the multilayer film functions as an anti-reflection film.

**19.** The optical member according to any one of claims 14 to 18, wherein:

the multilayer film further comprises a low refractive index layer having a refractive index lower than that of the substrate; and
the low refractive index layer is a $SiO_2$ layer.

**20.** The optical member according to any one of claims 1 to 5 and 14 to 19, wherein the Cu-proof protective layer has a thickness satisfying a condition nd = $\lambda$/2, where $\lambda$ is a wavelength of light entering the optical member and n is a refractive index of the Cu-proof protective layer.

**21.** The optical member according to any one of claims 1 to 5 and 14 to 20, wherein the Cu-proof protective layer is composed of any one of $Al_2O_3$, $Ta_2O_5$, MgO, and $HfO_2$ or a mixture of any two or more of $Al_2O_3$, $Ta_2O_5$, MgO, and $HfO_2$.

**22.** The optical member according to any one of claims 1 to 5 and 14 to 21, wherein the Cu-proof protective layer is a $HfO_2$ layer.

**23.** The optical member according to any one of claims 1 to 5 and 19, further comprising a high refractive index layer formed between the substrate and the low refractive index layer, the high refractive index layer having a refractive index higher than a refractive index of the substrate.

**24.** The optical member according to claim 23, wherein the Cu-proof protective layer and the high refractive index layer are composed of a same material.

**25.** The optical member according to claim 24, wherein the Cu-proof protective layer and the high refractive index layer are $HfO_2$ layers.

**26.** The optical member according to any one of claims 1 to 25, wherein the substrate is an $Al_2O_3$ substrate.

**27.** A chamber in which chlorine gas is sealed, the chamber comprising:

a light transmitting window formed in the chamber;
the light transmitting window being made of the optical member according to any one of claims 1 to 26.

**28.** A light source device comprising:

the chamber according to claim 27; and
an electrode disposed in the chamber and containing Cu.

**29.** The light source device according to claim 28, wherein the light source device is a XeCl excimer laser light source device.

**30.** A light transmitting window for an excimer laser light source device, the light transmitting window being made of the optical member according to any one of claims 1 to 26.

FIG. 1

FIG. 2

| EXAMPLE | | 1 | | | 2 | | | 3 | | |
|---|---|---|---|---|---|---|---|---|---|---|
| | | MATERIAL | REFRACTIVE INDEX | FILM THICKNESS (μm) | MATERIAL | REFRACTIVE INDEX | FILM THICKNESS (μm) | MATERIAL | REFRACTIVE INDEX | FILM THICKNESS (μm) |
| SURFACE LAYER | FIRST LAYER | $HfO_2$ | 2.053 | 0.038 | $HfO_2$ | 2.053 | 0.075 | $HfO_2$ | 2.053 | 0.038 |
| | SECOND LAYER | $SiO_2$ | 1.486 | 0.052 | $SiO_2$ | 1.486 | 0.052 | $SiO_2$ | 1.486 | 0.052 |
| | THIRD LAYER | | | | | | | $HfO_2$ | 2.053 | 0.038 |
| | SUBSTRATE | $Al_2O_3$ | 1.811 | | $Al_2O_3$ | 1.811 | | $Al_2O_3$ | 1.811 | |
| TRANSMITTANCE (%) | | 76.8 | | | 96.2 | | | 64.4 | | |

| EXAMPLE | | 4 | | | 5 | | | 6 | | |
|---|---|---|---|---|---|---|---|---|---|---|
| | | MATERIAL | REFRACTIVE INDEX | FILM THICKNESS (μm) | MATERIAL | REFRACTIVE INDEX | FILM THICKNESS (μm) | MATERIAL | REFRACTIVE INDEX | FILM THICKNESS (μm) |
| SURFACE LAYER | FIRST LAYER | $HfO_2$ | 2.053 | 0.075 | $HfO_2$ | 2.053 | 0.038 | $HfO_2$ | 2.053 | 0.038 |
| | SECOND LAYER | $SiO_2$ | 1.486 | 0.052 | $SiO_2$ | 1.486 | 0.104 | $SiO_2$ | 1.486 | 0.052 |
| | THIRD LAYER | $HfO_2$ | 2.053 | 0.038 | $HfO_2$ | 2.053 | 0.038 | $HfO_2$ | 2.053 | 0.075 |
| | SUBSTRATE | $Al_2O_3$ | 1.811 | | $Al_2O_3$ | 1.811 | | $Al_2O_3$ | 1.811 | |
| TRANSMITTANCE (%) | | 99.9 | | | 88.0 | | | 64.4 | | |

# FIG. 3

| COMPARATIVE EXAMPLE | | MATERIAL | REFRACTIVE INDEX | FILM THICKNESS (μm) | MATERIAL | REFRACTIVE INDEX | FILM THICKNESS (μm) |
|---|---|---|---|---|---|---|---|
| | | | 1 | | | 2 | |
| SURFACE LAYER | FIRST LAYER | $SiO_2$ | 1.486 | 0.052 | $SiO_2$ | 1.486 | 0.052 |
| | SECOND LAYER | $HfO_2$ | 2.053 | 0.038 | $HfO_2$ | 2.053 | 0.038 |
| | THIRD LAYER | | | | $SiO_2$ | 1.486 | 0.052 |
| | SUBSTRATE | $Al_2O_3$ | 1.811 | | $Al_2O_3$ | 1.811 | |
| TRANSMITTANCE (%) | | | 99.9 | | | 98.4 | |

# FIG. 4

# FIG. 5

FIG. 6

FIG. 7

FIG. 8

FIG. 9A

$n_1, d_1$

$n_s$

FIG. 9B

$n_0$

$n_s$

FIG. 9C

$n_2, d_2$

$n_1, d_1$

$n_s$

**INTERNATIONAL SEARCH REPORT**

| International application No. |
| --- |
| PCT/JP2016/078183 |

**A. CLASSIFICATION OF SUBJECT MATTER**

*G02B1/115*(2015.01)i, *G03F7/20*(2006.01)i, *H01S3/034*(2006.01)i

According to International Patent Classification (IPC) or to both national classification and IPC

**B. FIELDS SEARCHED**

Minimum documentation searched (classification system followed by classification symbols)
G02B1/115, G03F7/20, H01S3/034

Documentation searched other than minimum documentation to the extent that such documents are included in the fields searched

| Jitsuyo Shinan Koho | 1922–1996 | Jitsuyo Shinan Toroku Koho | 1996–2016 |
| Kokai Jitsuyo Shinan Koho | 1971–2016 | Toroku Jitsuyo Shinan Koho | 1994–2016 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | JP 2002-526804 A (Applied Materials Inc.),<br>20 August 2002 (20.08.2002),<br>paragraphs [0004], [0006], [0037], [0041],<br>[0043] to [0044], [0047], [0056]; fig. 9<br>& WO 2000/020900 A2<br>page 1, line 6 to page 3, line 5; page 2, lines<br>8 to 16; page 5, line 27 to page 6, line 2;<br>page 10, line 8 to page 11, line 2; page 14,<br>line 29 to page 15, line 6; page 16, line 5 to<br>page 17, line 30; page 18, lines 6 to 32; page<br>22, line 24 to page 23, line 6; fig. 9<br>& US 2003/0089992 A1    & EP 1118025 A2<br>& KR 10-2007-0005025 A | 1-5,20,23-24<br>21-22,25-26<br>14-19 |

| ☒ Further documents are listed in the continuation of Box C. | ☐ See patent family annex. |

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>08 December 2016 (08.12.16) | Date of mailing of the international search report<br>20 December 2016 (20.12.16) |
| --- | --- |
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

**INTERNATIONAL SEARCH REPORT**

International application No.

PCT/JP2016/078183

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2002-311209 A  (Nikon Corp.),<br>23 October 2002 (23.10.2002),<br>paragraphs [0011], [0014]<br>(Family: none) | 21-22,25 |
| Y | JP 2000-314803 A  (Canon Inc.),<br>14 November 2000 (14.11.2000),<br>paragraph [0030]<br>(Family: none) | 26 |
| Y | JP 2003-313438 A  (Kaneka Corp.),<br>06 November 2003 (06.11.2003),<br>paragraphs [0223], [0240]<br>(Family: none) | 26 |
| Y | WO 2003/092081 A1  (Nichia Chemical Industries, Ltd.),<br>06 November 2003 (06.11.2003),<br>paragraph [0054]<br>& US 2005/0179364 A1<br>paragraph [0108]<br>& US 2008/0315235 A1    & EP 1503428 A1<br>& AU 2002251550 A | 26 |
| X<br>Y | JP 6-250015 A  (Mitsubishi Electric Corp.),<br>09 September 1994 (09.09.1994),<br>paragraphs [0005], [0012]; fig. 2, 3<br>(Family: none) | 6-7,10-13,30<br>8-9,27-29 |
| Y | JP 62-123401 A  (Nippon Kogaku Kogyo Kabushiki Kaisha),<br>04 June 1987 (04.06.1987),<br>page 1, lower left column, line 15 to page 2, upper left column, line 5; page 2, lower left column, lines 17 to 18<br>(Family: none) | 8-9 |
| Y | JP 63-113502 A  (Canon Inc.),<br>18 May 1988 (18.05.1988),<br>page 2, upper left column, line 18 to lower left column, line 12<br>(Family: none) | 27-29 |
| Y | JP 5-29682 A  (Komatsu Ltd.),<br>05 February 1993 (05.02.1993),<br>paragraphs [0002], [0006]<br>(Family: none) | 28-29 |
| A | JP 2012-219185 A  (Hitachi Chemical Techno Service Co., Ltd.),<br>12 November 2012 (12.11.2012),<br>paragraph [0011]<br>(Family: none) | 6-13 |

Form PCT/ISA/210 (continuation of second sheet) (January 2015)

EP 3 358 377 A1

## INTERNATIONAL SEARCH REPORT

| International application No. |
|---|
| PCT/JP2016/078183 |

---

**Box No. II**    **Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

---

**Box No. III**    **Observations where unity of invention is lacking (Continuation of item 3 of first sheet)**

This International Searching Authority found multiple inventions in this international application, as follows:

    See extra sheet.

1. ☒ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.    Consequently, this international search report is restricted to the invention first mentioned in the claims; it is covered by claims Nos.:

**Remark on Protest**        ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☒ No protest accompanied the payment of additional search fees.

Form PCT/ISA/210 (continuation of first sheet (2)) (January 2015)

23

**INTERNATIONAL SEARCH REPORT**

International application No.

PCT/JP2016/078183

Continuation of Box No.III of continuation of first sheet(2)

Document 1: JP 2002-526804 A (Applied Materials Inc.), 20 August 2002 (20.08.2002), paragraphs [0006], [0041], [0047], [0056]; fig. 9 & WO 2000/020900 A2 page 2, line 28 to page 3, line 5; page 16, lines 5 to 17; page 18, lines 16 to 32; page 22, line 24 to page 23, line 6; fig. 9 & US 2003/0089992 A1 & EP 1118025 A2 & KR 10-2007-0005025 A
Claims are classified into the following three inventions.
(Invention 1) claims 1-5, 10-13 and 15-30
Document 1 (paragraphs [0006], [0037], [0041], [0047], [0056], and Fig. 9) has set forth an optical member formed by laminating, in the following order on a substrate including a dielectric layer 60, a contact 62, a barrier layer 64, and a dielectric layer 66, an etch stop 68 formed of SiC (refractive index 1.9, wavelength 633 nm), and a dielectric layer 70 formed of USG ($SiO_2$), and an ARC 72 (Cu-resistant protection layer, antireflection film) formed of SiC. Since the barrier layer 64 and the dielectric layer 66, which form the substrate, are configured from SiC and USG, it is considered that the refractive index of the substrate is equal to or more than that of USG.
Therefore, the inventions of claims 1-4 do not have novelty and a special technical feature in the light of the document 1.
However, claim 5, i.e., a dependent claim of claim 1, has a special technical feature of an "optical member having a transmittance equal to or more than 90 % with respect to perpendicularly inputted light having a wavelength of 308 nm", and claims 20-30 dependent on claim 5, claim 10, claims 11-13 dependent on claim 10, claim 15, claims 18-19 dependent on claim 15, and claim 16 have the special technical feature same as that of claim 5.
Consequently, claims 1-5, 10-13 and 15-30 are classified into Invention 1.
(Invention 2) claims 6-9
It is not considered that claim 6 has a special technical feature same as or corresponding to claim 5 which is classified into Invention 1.
Further, claim 6 is not dependent on claim 1.
In addition, claim 6 has no relationship such that said claim 6 is substantially same as or equivalent to any claim classified into Invention 1.
Therefore, claims 6-9 involving claim 7-9 referring to claim 6 cannot be classified into Invention 1.
Since claim 6 has a special technical feature of an "optical member having a permeable film including an outermost layer configured from one of, or a composite containing two or more of $Al_2O_3$, $Ta_2O_5$, MgO, and $HfO_2$", the invention of the claim is classified as the invention of the invention group 2.
(Invention 3) claim 14
It is not considered that claim 14 has a special technical feature same as or corresponding to claim 5 classified into Invention 1 or claim 6 classified into Invention 2.
Further, claim 14 is not dependent on either claim 1 or 6.
In addition, claim 14 has no relationship such that said claim 14 is substantially same as or equivalent to any claim classified into Invention 1 or Invention 2.

(Continued to next extra sheet)

Form PCT/ISA/210 (extra sheet) (January 2015)

**INTERNATIONAL SEARCH REPORT**

| International application No. |
| --- |
| PCT/JP2016/078183 |

Consequently, since claim 14 has a special technical feature of an "optical member, which has a multilayer film including a plurality of layers having different refractive indexes, and in which a Cu diffusion coefficient of a Cu-resistant protection film at 200°C is equal to or less than 1/10 of the Cu diffusion coefficient of $SiO_2$ at 200°C", the invention of the claim is classified as the invention of the invention group 3.

Form PCT/ISA/210 (extra sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004039660 A

**Non-patent literature cited in the description**

- *Applied Physics,* 1996, vol. B63, 229-235
- *Jpn. J, Appl. Phys.,* 1999, vol. 38, 5792-5795